# EUROPÄISCHE PATENTSCHRIFT

(11) **EP 0 866 550 B1**
(45) Veröffentlichungstag und Bekanntmachung des Hinweises auf die Patenterteilung: **12.05.2004**
(21) Anmeldenummer: 98105062.8
(22) Anmeldetag: 20.03.1998
(51) Int. Cl.: H03G 3/30

(54) **Vorrichtung zur Pulsformung von Hochfrequenzsignalen**
Pulse forming device of high frequency signals
Dispositif de mise en forme d'impulsions radio haute-fréquence

(30) Priorität: 22.03.1997 DE 19712161
(43) Veröffentlichungstag der Anmeldung: 23.09.1998
(73) Patentinhaber: Lucent Technologies Network Systems GmbH, 90411 Nürnberg (DE)
(72) Erfinder: Saur, Erich, Dr., 90491 Nürnberg (DE)
(74) Vertreter: Watts, Christopher Malcolm Kelway, Dr.

(56) Entgegenhaltungen:
- GB-A- 2 060 292
- GB-A- 2 281 461
- US-A- 5 416 441
- US-A- 5 697 073

## Beschreibung

Die Erfindung bezieht sich auf eine Vorrichtung zur Erzeugung von Hochfrequenzsignalen mit unterschiedlichen Leistungspegeln nach dem Oberbegriff des Anspruches 1, insbesondere zur Pulsformung von Sendebursts in einem zellularen TDMA-Mobilfunksystem, wie z.B. GSM, DCS 1800 oder PCS 1900.

Ein Sender eines TDMA-(Time Division Multiple Access) Systems ist üblicherweise derart konzipiert, dass in individuellen Sende-Zeitschlitzen Hochfrequenzsignale mit unterschiedlichen Ausgangs- oder Leistungspegeln gesendet werden können. Auf diese Weise wird in jedem Zeitschlitz, der jeweils einem Funkkanal zugeordnet ist, jeweils die Sendeleistung derart eingestellt, dass trotz unterschiedlicher Entfernungen zwischen der Basisstation und den Mobilstationen gerade noch eine störungsfreie Übertragung möglich wird. Da jeder Funkkanal mit minimaler Sendeenergie betrieben wird, ergibt sich wegen verminderter Gleichkanal- und Nachbarkanalstörungen im Gesamtsystem ein insgesamt minimierter Interferenzpegel. Insbesondere bei GSM-Sendern besteht die Forderung, dass ein Sendesignal oder Sendeburst im Burst-Plateau in definierten Leistungsstufen mit sehr geringer Toleranz einstellbar sein muß. Darüber hinaus müssen auch die Burst-Flanken innerhalb einer definierten Amplitudenschablone liegen, wobei gleichzeitig ein aufgrund der Flankensteilheit des Bursts verursachtes Störspektrum innerhalb eines zulässigen Bereichs liegen muß. Ein unzulässiges Störspektrum würde zu Störungen benachbarter Sende-/Empfangskanäle führen.

Die EP 08 59 463 A2 gilt gemäß Art. 54(3) und (4) als Stand der Technik und zeigt eine Vorrichtung zur Impulsformung von Hochfrequenzsignalen mit unterschiedlichen Leistungspegeln, wobei ein erstes Stellglied zur Einstellung eines Leistungspegels eines Pulsplateaus durch einen einstellbaren Abschwächer und ein zweites Stellglied zur Einstellung einer Anzahl von Pegelwerten zur Formung der jeweiligen Pulsflanken durch einen steuerbaren Verstärker gebildet werden. Ferner ist ein D/A Wandler des ersten Stellgliedes vorgesehen und beide Steuereinheiten werden durch eine Systemeinheit koordiniert gesteuert. Die Vorrichtung ist Bestandteil eines TDMA-Senders.

Bei einer oberbegrifflichen Vorrichtung (GB-A 2 060 292) ist ein Sendepegel-Regelsystem mit einem variablen Abschwächer vorgesehen, der einen geschalteten Abschwächer und einen kontinuierlich veränderbaren Abschwächer aufweist. Der variable Abschwächer wird von Sensoren gesteuert, die das Verhältnis Spannung zu stehender Welle bzw. Strom zu Spannung abtasten und mit Sollwerten vergleichen. Die Grobeinstellung erfolgt mit dem geschalteten Abschwächer und die Feineinstellung mit dem veränderbaren Abschwächer. Dies bedingt einen nicht unerheblichen Aufwand bei der Realisierung der Schaltung.

Bei einem aus der DE 39 40 295 A1 bekannten Hochfrequenzsender mit geregelter Ausgangsleistung wird ein Teil der Ausgangsleistung eines Hochfrequenz-Leistungsverstärkers durch einen an dessen Ausgang liegenden Richtkoppler ausgekoppelt. Die ausgekoppelte Hochfrequenz (HF)-Leistung wird zunächst gleichgerichtet und invertiert einem Regelverstärker als Istwert zugeführt. Mittels eines Sollwertgebers wird entsprechend einer gewünschten Ausgangsleistung dem Regelverstarker eine elektrische Spannung vorgegeben. Aus der Spannungsdifferenz zwischen Sollwertspannung und Istwertspannung erzeugt der Regelverstärker eine Stellspannung, die über einen Steuereingang einem HF-Verstärker zugeführt wird. Der Ausgang des HF-Verstärkers oder -Vorverstärkers ist mit dem Eingang einer HF-Endstufe (Leistungsverstärker) verbunden, so daß auf diese Weise ein geschlossener Regelkreis entsteht. Der Aufwand zur Realisierung eines solchen Regelkreises ist jedoch besonders hoch, da zur Gewährleistung eines ausreichend hohen Dynamikumfangs des Regelkreises bei allen Betriebsbedingungen eine Vielzahl von Parametern gemessen und kompensiert werden müssen. Insbesondere müssen mehrere Parameter zur Kompensation der Nichtlinearität und einer Temperaturdrift des Sendeverstärkers erfaßt werden.

Übliche Hochfrequenz-Leistungsverstärker weisen in der Regel eine nichtlineare Übertragungsfunktion auf. so daß ein Eingangssignal zumindest über einen großen Pegelbereich nicht proportional zu dessen Leistung verstärkt wird. Verstärker mit einem zusätzlichen Steuereingang zur Verstarkungseinstellung zeigen ebenfalls eine nichtlineare Abhängigkeit zwischen einer Steuer- oder Stellspannung und der Ausgangsleistung des Verstärkers. Eine präzise Einstellung definierter Leistungsstufen oder Leistungspegel mit geringer Toleranz, insbesondere für Bursts hoher Dynamik, ist daher bisher nur mit erheblichem Aufwand möglich.

Der Erfindung liegt daher die Aufgabe zugrunde, eine Vorrichtung zur Pulsformung von Hochfrequenzsignalen, insbesondere zur Erzeugung von Bursts, anzugeben, die eine präzise Einstellung von unterschiedlichen Leistungspegeln bei hoher Burst-Dynamik mit besonders geringem Aufwand ermöglicht.

Diese Aufgabe wird erfindungsgemäß gelöst durch die Merkmale des Anspruchs 1. Dabei sind zur Pulsformung von Hochfrequenz- oder Burst-Signalen zwei separate Stellglieder zur Einstellung eines Leistungspegels eines Puls- oder Burstplateaus einerseits sowie zur Einstellung einer Anzahl von Pegelwerten zur Formung der jeweiligen Pulsflanke andererseits vorgesehen. Zur Pegeleinstellung wird ein stufenweise einstellbarer Abschwächer eingesetzt, während zur Formung der Pulsflanken ein steuerbarer Verstärker verwendet wird.

Die Erfindung geht von der Überlegung aus, daß bei der Erzeugung von Hochfrequenz-Bursts hoher Dynamik auf eine Regelschleife verzichtet werden kann, wenn die unterschiedlichen Leistungspegel des Burst- oder Puls-Plateaus einerseits und die Leistung während der Bursts- bzw. Pulsflanken andererseits voneinander getrennt eingestellt werden. Bei TDMA-Systemen, wie z.B. GSM, besteht eine hohe Genauigkeitsanforderung bezüglich der Leistungspegel während der Burstplateaus. Demgegenüber spielt die Leistungseinstellung innerhalb der Burstflanken eine untergeordnete Rolle, solange die Monotonie der Übertragungscharakteristik und die Einhaltung des zulässigen Schaltspektrums gewährleistet bleiben. Insgesamt kann durch geeignete Kombination zweier Stellglieder ein Stellbereich von über 90 dB realisiert werden. Davon wiederum ist dann - abhängig von der Linearität des steuerbaren Verstärkers - ein Plateau-Dynamikbereich von über 50 dB mit hoher absoluter Genauigkeit stellbar.

Das erste Stellglied, das die präzise Einstellung des jeweils erfoderlichen Leistungspegels innerhalb des Burstplateaus vornimmt, ist in einer bevorzugten Ausführungsform ein digitaler Stufenabschwächer mit einer Anzahl von binären Stufen. Dadurch werden eine Vielzahl von Abschwächungsschritten in kleinen Dämpfungsstufen realisiert werden. Als zweites Stellglied, das die relativ ungenaue Steuerung der Leistungsänderung während der Burstflanken übernimmt, wird ein steuerbarer Leistungsverstärker verwendet. Der Eingangsleistungspegel dieses Leistungsverstärkers wird zweckmäßigerweise derart gewählt, daß dessen Ausgangsleistung bei minimaler Dämpfung des eingangsseitig als erstes Stellglied vorgeschalteten Stufenabschwächers nur einen geringen Betrag unterhalb dessen 1dB-Kompressionspunktes liegt. Da übliche Verstärker, die für den Betrieb im Arbeitspunktbereich (AB) ausgelegt sind, unterhalb des 1 dB-Kompressionspunktes einen linearen Verstärkungsbereich von über 45 dB aufweisen, werden entsprechende Eingangssignale, die sich innerhalb dieses linearen Dynamikbereichs befinden, mit einem kleinen relativen Fehler zum Ausgang übertragen. Bei heute auf dem Markt erhältlichen MMIC (Monolithic Microwave Integrated Circuit)-Verstärkern beträgt dieser Linearitätsfehler weniger als ±1 dB über einen Dynamikbereich von fast 50 dB unterhalb des 1 dB-Kompressionspunktes. Folglich bleiben innerhalb dieses Bereichs am Eingang des Verstärkers durch das erste Stellglied vorgegebene Signalpegel in deren relativem Abstand am Ausgang des Verstärkers erhalten. Lediglich die Pegel erhöhen sich entsprechend der Verstärkung des Verstärkers.

Zur Absenkung des Burstpegels unterhalb des untersten Plateauniveaus dient der Steuereingang des steuerbaren Verstärkers. Durch eine entsprechend gesteuerte Spannung wird die Ausgangsleistung des Verstärkers entsprechend der geforderten Flankensteilheit herauf- oder herabgefahren. Dabei ist in der Regel keine besondere Pegelgenauigkeit erforderlich. Dieser ungenaue Stellbereich des steuerbaren Verstärkers kann bei Verwendung üblicher Bauelemente bis zu etwa 50 dB betragen.

Das Zusammenwirken der beiden Stellglieder auf das Hochfrequenzsignal oder auf dessen Bursts wird von einer CPU gesteuert, beispielsweise durch DIA-Wandler (DAC, Digital-Analog-Converter). So kann z. B. ein erster, dem ersten Stellglied zugeordneter D/A-Wandler die in einem GSM-Sender spezifizierten 21 Leistungsstufen in Schritten von 2 dB steuern, während ein zweiter, dem zweiten Stellglied zugeordneter D/A-Wandler durch Ausgabe von einigen wenigen Werten die Pulsflanken des jeweiligen Bursts formt. Dazu steuert der zweite D/A-Wandler das durch den Verstärker realisierte zweite Stellglied zwischen einer Sättigungsleistung und einer Minimalleistung aufwärts oder abwärts, wobei zur Pulsglättung dem oder jedem D/A-Wandler vorzugsweise ein Tiefpaßfilter nachgeschaltet ist. Bei Verwendung jeweils eines D/A-Wandlers für jedes der Stellglieder weisen die entsprechenden Tiefpaßfilter unterschiedliche Zeitkonstanten auf.

Zur weiteren Verstärkung der Ausgangsleistung aus dem als zweites Stellglied dienenden steuerbaren Verstärker kann diesem ein Leistungsverstärker (Endstufe) nachgeschaltet sein. Diese z. B. mit einer festen Verstärkung ausgelegte Endstufe wird analog zum zweiten Stellglied ebenfalls im Bereich unterhalb der Sättigungsleistung betrieben, so daß die in der vorgeschalteten Pulsformungsvorrichtung eingestellte Leistung proportional weiterverstärkt wird. Dabei bleibt die Linearität der Pegeleinstellung erhalten, so daß mit jeweils einem Stellwert die Pegelleistung und damit das Burst-Plateau eingestellt werden kann. Bei Verwendung einer Endstufe in Form eines ebenfalls einstellbaren Leistungsverstärkers arbeitet das zweite Stellglied als Vorverstärker.

Die mit der Erfindung erzielten Vorteile bestehen insbesondere darin. daß TDMA-Bursts sehr kostengünstig in einfacher Weise und mit hoher Dynamik erzeugt werden können. Dabei ist mit üblichen Bauelementen eine Burst-Dynamik von über 90 dB mit geringem Aufwand realisierbar.

Die Vorrichtung kann stets in solchen Fällen Verwendung finden, in denen eine Pulsformung von Hochfrequenzsignalen großer Dynamik unter Einsatz einfacher und kostengünstiger Mittel gewünscht oder gefordert ist. Sie eignet sich daher besonders für den Einsatz in TDMA-Sendern innerhalb des GSM-Systems, da einerseits durch Verwendung eines Abschwächers als erstes Stellglied in kleinen definierten Leistungsschritten, z. B. in einem 2-dB-Raster (Ramping), die Leistung . eines Bursts eines Hochfrequenzsignals innerhalb eines Zeitschlitz-Mehrfachzugriffssystems (TDMA) von einem Zeitschlitz zum nächsten Zeitschlitz mit hoher Genauigkeit eingestellt werden kann. Andererseits kann mittels des zweiten Stellglieds in Form eines steuerbaren Verstärkers die Flankensteilheit auch eines Bursts hoher Dynamik beherrscht werden, so daß ein zulässiges Störspektrum eingehalten wird und Störungen durch Nebenausstrahlungen vermieden sind.

Ausführungsbeispiele der Erfindung werden anhand einer Zeichnung näher erläutert. Darin zeigen:
- Fig. 1: schematisch eine Vorrichtung zur Erzeugung von Hochfrequenzsignalen mit Stellgliedern zur Pegeleinstellung,
- Fig. 2: in einem Leistungspegel/Zeit-Diagramm ein Hochfrequenzsignal mit unterschiedlichen Burst-Plateaus,
- Fig. 3: in einem Verstärkungs/Leistungs-Diagramm den Verstärkungsgäng eines Leistungsverstärkers,
- Fig. 4: eine Leistungsstufensteuerschaltung mit einem digitalen Stufenabschwächer und
- Fig. 5: in einem Leistungspegel/Zeit-Diagramm ein typisches Hochfrequenzsignal innerhalb eines TDMA-Systems.

Einander entsprechende Teile sind in allen Figuren mit den gleichen Bezugszeichen versehen.

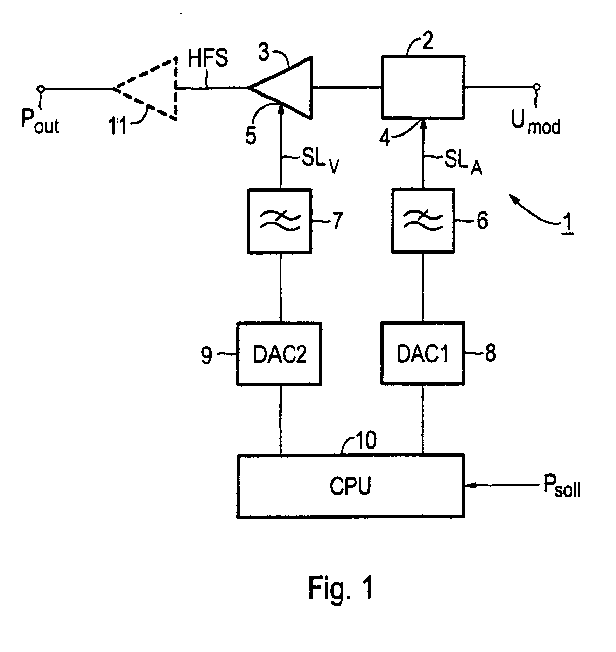

Fig. 1 zeigt schematisch eine Stellvorrichtung 1 zur Burst-Erzeugung eines Hochfrequenz oder HF-Signals mit einem ersten Stellglied 2 in Form eines Abschwächers und mit einem dem ersten Stellglied 2 nachgeschalteten zweiten Stellglied 3 in Form eines steuerbaren Verstärkers 3. Das erste Stellglied 2 ist z. B. ein auf Pin-Dioden basierendes elektronisches Dämpfungsglied . Der Abschwächer 2 und der steuerbare Verstärker 3 weisen jeweils einen Steuereingang 4 bzw. 5 auf, die über jeweils einen Tiefpaßfilter 6, 7 und einen diesem vorgeschalteten Digital/Analog-Wandler 8 (DAC1) bzw. 9 (DAC2) an eine zentrale Steuereinrichtung 10 (CPU) angeschlossen sind. Anhand eines der Steuereinrichtung 10 zuführbaren Leistungssollwerts Pₛₒₗₗ wird die jeweilige Ausgangsleistung der beiden Stellglieder 2 und 3 eingestellt. Dem Verstärker 3 kann zur Erzielung einer weiter verstärkten Ausgangsleistung Pₒᵤₜ ein Leistungsverstärker 11 nachgeschaltet sein. Der Stellvorrichtung 1 wird eingangsseitig ein Modulationssignal U_{mod} zugeführt.

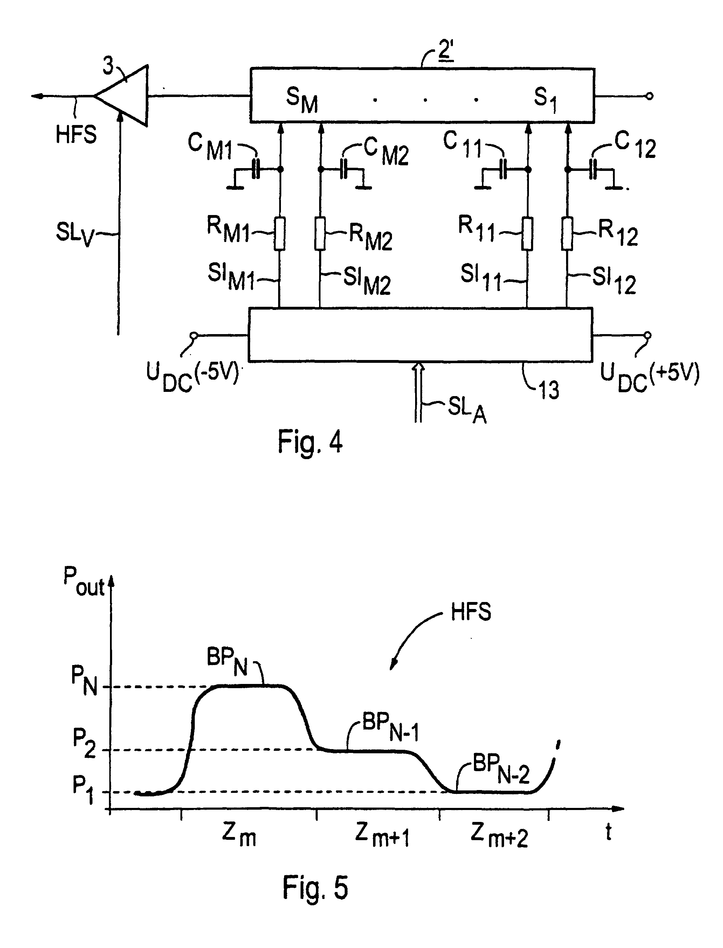

Durch geeignete Einstellung von Steuerspannungen SL_{A} und SL_{V} an den jeweiligen Steuereingängen 4 bzw. 5 erfolgt die Erzeugung einer Folge von Sendebursts mit Platauleistungspegeln BP_{N} innerhalb von Zeitschlitzen Zₘ, (Fig. 5)

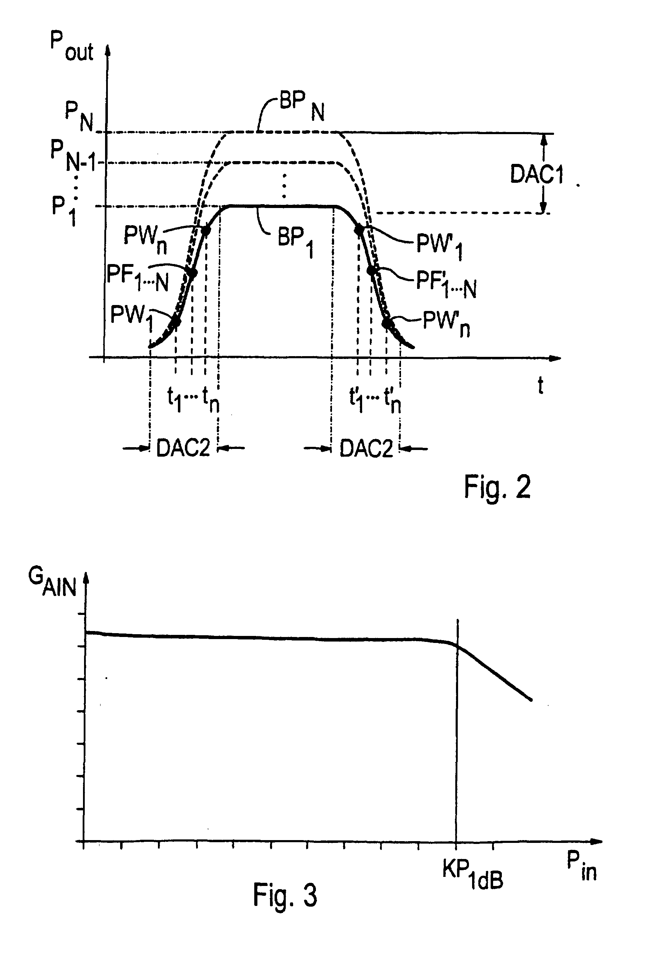

Der Abschwächer 2 dient zur Einstellung unterschiedlicher Leistungspegel P_{1 N} eines jeweiligen Sendebursts (Fig. 2). Da übliche HF-Verstärker im allgemeinen - im Bereich-unterhalb deren Sättigungsleistung einen Verstärkungsgang aufweisen, wie er in Fig. 3 in einem Verstärkungs (Gain)/Leistungs (Pᵢₙ)-Diagramm qualitativ dargestellt ist, wird die im Abschwächer 2 eingestellte Leistung P_{1..N} im Verstärker 3 proportional weiterverstärkt, so daß die Linearität der Pegeleinstellung erhalten bleibt. Dabei ist mit KP_{1dB} der 1dB-Kompressionspunkt bezeichnet. Somit kann innerhalb dieses näherungsweise linearen Bereichs mit jeweils einem Stellwert der Steuerspannung SL_{A} die Plateauleistung eines HF-Bursts des Hochfrequenzsignals HFS eingestellt werden.

Fig. 2 zeigt qualitativ das Zusammenwirken der beiden Stellglieder 2 und 3 auf einen HF-Burst. Dargestellt sind verschiedene Leistungspegel P_{1 .N} von Pulsplateaus BP_{1 N} einzelner Bursts des Hochfrequenzsignals HFS in einem Ausgangsleistungs- oder Leistungspegel/Zeit-Diagramm. Durch die Verstärkungseinstellung des Verstärkers 3 mittels der Steuerspannung SL_{V} kann zudem die Leistung innerhalb jeder Burst- oder Pulsflanke PF_{1 N} und PF'_{1.. N} durch Einstellung einiger Leistungswerte PW_{1 . n} bzw. PW'_{1 n} hinauf- bzw. heruntergefahren werden. Die Glättung der Steuerspannung SL_{V} zwischen diesen Stützwerten kann z.B. mittels des Tiefpaßfilters 7 erfolgen.

Als Verstärker 3 wird zweckmäßigerweise ein hybrides Verstärkermodul oder ein integrierter Verstärker (MMIC) mit einem Stellbereich von vorzugsweise 50 dB eingesetzt. Das Zusammenwirken des Verstärkers 3 und des Abschwächers 2 wird durch die beiden D/A-Wandler 8 und 9 gesteuert. Dabei steuert der Wandler 8 z. B. in einem GSM-(Global System for Mobile Communication) Sender die in der GSM-Spezifikation definierten 21 Leistungsstufen P_{1 N} in 2 dB-Schritten, so daß sich zwischen dem minimalen Leistungspegel P₁ des entsprechenden Burstplateaus BP₁ und dem maximalen Leistungspegel P_{N=21} des entsprechenden Burstplateaus BP_{N} insgesamt eine Differenz von 42 dB ergibt. Der Wandler 9 formt durch Ausgabe von einigen wenigen Pulswerten, die im Tiefpaßfilter 7 geglättet werden, die Pulsflanken PF_{1 N} PF'_{1 N} des jeweiligen Bursts. Dazu werden zu den Anstiegszeiten t_{1 n} und t'_{1 n} die entsprechenden Leistungswerte PW_{1 n} bzw. PW'_{1 n} eingestellt. Während die Filterzeitkonstante des vorzugsweise 5Bit-Wandlers 8 (DAC1) mit ca. 10 µs relativ lang ist. ist die Filterzeitkonstante des vorzugsweise 3Bit-Wandlers 9 (DAC2) mit ca. 2 µs relativ kurz.

Fig. 4 zeigt eine bevorzugte Ausführungsvariante des ersten Stellglieds 2 in Form eines digitalen Stufenabschwächers 2'. Bei Einsatz eines derartigen Stufenabschwächers 2' anstelle eines kontinuierlichen Abschwächers 2 kann der Wandler 8 (DAC1) eingespart werden. Der Stufenabschwächer 2' weist eine Anzahl von binären Einstellstufen S_{1 M} auf, so daß bei Einsatz eines entsprechenden Treibers 13 mit N Bits insgesamt 2^{M} Abschwächungsstufen mit z. B. jeweils 1 dB eingestellt werden können. So werden z. B. mit einem 6-Bit-Treiber 13 insgesamt vierundsechzig (64) Abschwächungsschritte oder -stufen realisiert. Der digitale Treiber 13 weist zwei Spannungsanschlüsse für eine positive und eine negative Gleichspannung U_{DC}(-5V) bzw. U_{DC}(+5V) auf.

Jeder Einstellstufe S_{M} des Stufenabschwächers 2' sind zwei differentielle Steuerspannungsanschlüsse zugeordnet, von denen jeder über ein RC-Glied mit jeweils einem Widerstand R_{M1} bzw. R_{M2} und einem Kondensator C_{M1} bzw. C_{M2} mit dem Treiber 13 verbunden ist. Die RC-Glieder bewirken eine Glättung der vom Treiber 13 jeweils erzeugten Steuerimpulse SI_{M1}, SI_{M2}, so daß der Steuerimpuls SI_{M} _{1,2} quasi sanft oder kriechend den jeweiligen Schwellwert des Stufenabschwächers 2' überschreitet. Dadurch wird das Störspektrum begrenzt, welches durch die Flankensteilheit der Stellspannung verursacht werden kann. Durch die abgerundete Form der Stellspannungsflanken wird sichergestellt, daß die Pulsflanken PF_{1 N} der Bursts des Hochfrequenzsignals HFS innerhalb einer geforderten Amplitudenschablone liegt.

Die Vorrichtung zur Burst-Erzeugung von Hochfrequenzsignalen HFS eignet sich besonders für den Einsatz in einem Sender eines Mobilfunksystems nach dem GSM-Standard für Zeitschlitz-Mehrfachzugriffsbetrieb (TDMA, Time Division Multiple Access), bei dem zu sendende und zu empfangende Signale zeitkomprimiert als Datenpakete zu jeweils unterschiedlichen Zeitpunkten gesendet bzw. empfangen werden. Ein typisches Hochfrequenzsignal HFS mit einer Anzahl von Bursts BP_{N} mit unterschiedlichen Leistungspegeln P_{N} innerhalb verschiedener Zeitschlitze Zₘ zeigt beispielhaft Fig. 5.

## Patentansprüche

1. Vorrichtung zur Pulsformung von Hochfrequenzsignalen (HFS) mit unterschiedlichen Leistungspegeln (BP_{1 ...N}), umfassend:
ein erstes Stellglied (2) zur Einstellung eines Leistungspegels (P_{N}) eines Pulsplateaus (BP_{N}), und ein zweites Stellglied (3) zur Einstellung einer Anzahl von Pegelwerten (PW_{1...n} PW'_{1...n}) zur Formung der jeweiligen Pulsflanken (PF_{1...N}, PF'_{1...N}),
**dadurch gekennzeichnet,**
**dass** das erste Stellglied ein einstellbarer Stufenabschwächer (2') mit digitalem Treiber (13) ist, der ausgangsseitig über jeweils mindestens ein RC-Glied (R_{M1},C_{M1}, R_{M2}, C_{M2}) mit einer Einstellstufe (S_{M}) des Stufenabschwächers (2') verbunden ist, und
**dass** das zweite Stellglied ein steuerbarer Verstärker (3) ist.

2. Vorrichtung nach Anspruch 1,
**dadurch gekennzeichnet, dass** ein D/A- Wandler (8, 9) zur Steuerung des oder jedes Stellglieds (2, 3) vorgesehen ist.

3. Vorrichtung nach Anspruch 2,
**dadurch gekennzeichnet, dass** die D/A-Wandler (8, 9) über Tiefpassfilter (6.7) mit den jeweiligen Stellgliedern (2, 3) verbunden sind.

4. Vorrichtung nach einem der Ansprüche 1 bis 3,
**dadurch gekennzeichnet, dass** dem zweiten Stellglied (3) ein Leistungsverstärker (12) nachgeschaltet ist.

5. Vorrichtung nach einem der Ansprüche 1 bis 4,
**dadurch gekennzeichnet, dass** die beiden Stellglieder (2, 3) durch eine Steuereinheit (10) koordiniert steuerbar sind.

6. Vorrichtung nach einem der Ansprüche 1 bis 5,
**dadurch gekennzeichnet, dass** die Elemente zur Pulsformung Bestandteil eines TDMA-Senders, insbesondere der Mobilfunksysteme GSM, DCS 1800 oder PCS 1900, sind.

## Claims

1. Pulse-shaping apparatus for radio-frequency signals (HFS) at different power levels (BP₁..._{N}), comprising:
a first control element (2) for setting a power level (P_{N}) of a pulse plateau (BP_{N}), and a second control element (3) for setting a number of level values (PW₁...ₙ PW'_{1...n}) for shaping the respective pulse flanks (PF_{1...N}, PF'_{1...n}),
**characterized**
**in that** the first control element is an adjustable step attenuator (2') with a digital driver (13) which is connected on the output side via in each case at least one RC element (R_{M1}, C_{M1}, R_{M2}, C_{M2}) to a setting stage (S_{M}) for the step attenuator (2') and,
**in that** the second control element is a controllable amplifier (3).

2. Apparatus according to Claim 1,
**characterized in that** a D/A converter (8, 9) is provided for controlling the or each control element (2, 3).

3. Apparatus according to Claim 2,
**characterized in that** the D/A converters (8, 9) are connected via low-pass filters (6, 7) to the respective control elements (2, 3).

4. Apparatus according to one of Claims 1 to 3,
**characterized in that** the second control element (3) is followed by a power amplifier (12).

5. Apparatus according to one of Claims 1 to 4,
**characterized in that** the two control elements (2, 3) can be controlled in a co-ordinated manner by a control unit (10).

6. Apparatus according to one of Claims 1 to 5,
**characterized in that** the pulse-shaping elements are a component of a TDMA transmitter, in particular for the GSM, DCS 1800 or PCS 1900 mobile radio systems.

## Revendications

1. Dispositif de mise en forme d'impulsions radio haute fréquence (HFS) de différents niveaux de puissance (BP_{1 ... N}), comprenant :
un premier élément de réglage (2) pour régler un niveau de puissance (P_{N}) d'un plateau d'impulsion (BP_{N}) et un deuxième élément de réglage (3) pour régler un certain nombre de valeurs de niveau (PW_{1...n}, PW'_{1...n}) pour mettre en forme les différents fronts d'impulsion (PF_{1...N}, PF'_{1...N}),
**caractérisé en ce**
**que** le premier élément de réglage est un atténuateur à paliers réglable (2') à circuit de commande numérique (13) dont la sortie est reliée à un étage de réglage (S_{M}) de l'atténuateur à paliers (2') à chaque fois par le biais d'au moins un réseau RC (R_{M1}, C_{M1}, R_{M2}, C_{M2}) et
**que** le deuxième élément de réglage est un amplificateur commandable (3).

2. Dispositif selon la revendication 1, **caractérisé en ce qu'**un convertisseur N/A (8, 9) est prévu pour commander le ou chaque élément de réglage (2, 3).

3. Dispositif selon la revendication 2, **caractérisé en ce que** le convertisseur N/A (8, 9) est relié avec les éléments de réglage (2, 3) respectifs par le biais de filtres passe-bas (6.7).

4. Dispositif selon l'une des revendications 1 à 3,
**caractérisé en ce qu'**un amplificateur de puissance (12) est branché à la suite du deuxième élément de réglage (3).

5. Dispositif selon l'une des revendications 1 à 4,
**caractérisé en ce que** les deux éléments de commande (2, 3) peuvent être commandés de manière coordonnée par une unité de commande (10).

6. Dispositif selon l'une des revendications 1 à 5,
**caractérisé en ce que** les éléments de mise en forme d'impulsions font partie d'un émetteur TDMA, notamment des systèmes de radiocommunication mobile GSM, DCS 1800 ou PCS 1900.
